# EUROPEAN PATENT APPLICATION

(11) **EP 4 737 791 A1**
(43) Date of publication of application: **06.05.2026**
(21) Application number: 25210822.0
(22) Date of filing: 23.10.2025
(51) Int. Cl.: F21K 9/62, H10H 29/24, H10H 29/85, F21Y 115/10, F21Y 113/13, F21Y 105/12, H10H 20/819, H10H 29/851, H10H 29/855, H10H 29/856

(54) **LIGHT-EMITTING MODULE**

(30) Priority: 29.10.2024 TW 113141214
(71) Applicant: Top Victory Investments Limited, Kwun Tong, Kowloon 999077 (HK)
(72) Inventor: HUANG, Tzu-Hung, 235603 New Taipei City (TW); LIN, Chih-Feng, 235603 New Taipei City (TW); CHUEH, Wan-Ting, 235603 New Taipei City (TW); CHEN, Chieh, 235603 New Taipei City (TW); LEE, Chin-Lun, 235603 New Taipei City (TW)
(74) Representative: Mewburn Ellis LLP

(57) **Abstract**

A light-emitting module (2) includes a housing and light-emitting units (25). The light-emitting units (25) are arranged along a first direction (X) and a second direction (Y) to form an array. Each of the light-emitting units (25) includes a first light-emitting element (252) and two second light-emitting elements (253). The second light-emitting elements (253) are disposed at two opposite sides of the first light-emitting element (252). A ratio of a length (253a) of any one of the second light-emitting elements (253) parallel to the first direction (X) to a length (252a) of the first light-emitting element (252) parallel to the first direction (X) ranges from 0.35 to 0.55. A sum of areas of upper surfaces of the second light-emitting elements (253) is not greater than an area of an upper surface of the first light-emitting element (252).

## Description

The disclosure relates to a light-emitting module, and more particularly to a light-emitting module of a light-emitting device.

Light-emitting diodes (LEDs) are usually used as light sources in conventional displays that are used in, for instance, phones, computers, televisions or large electronic advertising boards. In order to achieve vivid color quality, besides white LEDs that emit white light, LEDs that correspondingly emit light beams of three primary colors (red, green and blue) are used to achieve color mixing, and by adjusting proportion of the primary colors, desired colors are produced.

In order to achieve great color mixing quality and high-fidelity color rendering, light-emitting sources emitting three types of colors, i.e., red light (R), green light (G) and blue light (B), are mostly used. However, the light-emitting sources that are arranged in a display are often subject to dead zones in color mixing due to limitations in spatial arrangement thereof, and thus the displayed image exhibits color breakup, resulting in uneven color rendering, which in turn affects the viewing quality for audiences.

Therefore, how to reduce color breakup to attain good color mixing is one of development directions of the industry currently.

According to an aspect of the disclosure, there is provided a light-emitting module according to claim 1.

Other features and advantages of the disclosure will become apparent in the following detailed description of the embodiment(s) with reference to the accompanying drawings. It is noted that various features may not be drawn to scale.
FIG. 1 is a top view of a first embodiment of a light-emitting module according to the disclosure.
FIG. 2 is a sectional side view of the first embodiment.
FIG. 3 is a top view of a light-emitting unit contained in the first embodiment of the light-emitting module.
FIG. 4 to FIG. 6 are sectional side views respectively illustrating different distribution configurations of a phosphor material in the light-emitting unit of the first embodiment.
FIG. 7 is a top view of a second embodiment of the light-emitting module according to the disclosure.
FIG. 8 is a sectional side view of an embodiment of the light-emitting module according to the disclosure, illustrating lenses being disposed on light-emitting units of the light-emitting module.

Before the disclosure is described in greater detail, it should be noted that where considered appropriate, reference numerals or terminal portions of reference numerals have been repeated among the figures to indicate corresponding or analogous elements, which may optionally have similar characteristics.

It should be noted herein that for clarity of description, spatially relative terms such as "top," "bottom," "upper," "lower," "on," "above," "over," "downwardly," "upwardly" and the like may be used throughout the disclosure while making reference to the features as illustrated in the drawings. The features may be oriented differently (e.g., rotated 90 degrees or at other orientations) and the spatially relative terms used herein may be interpreted accordingly.

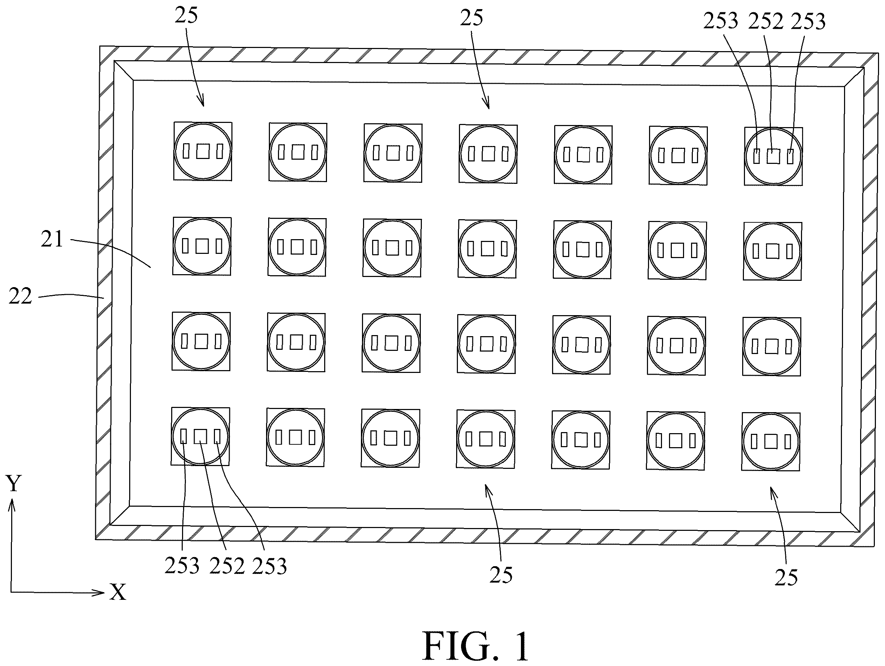

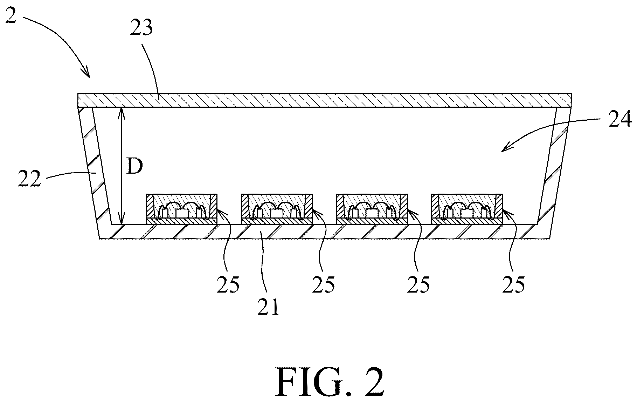

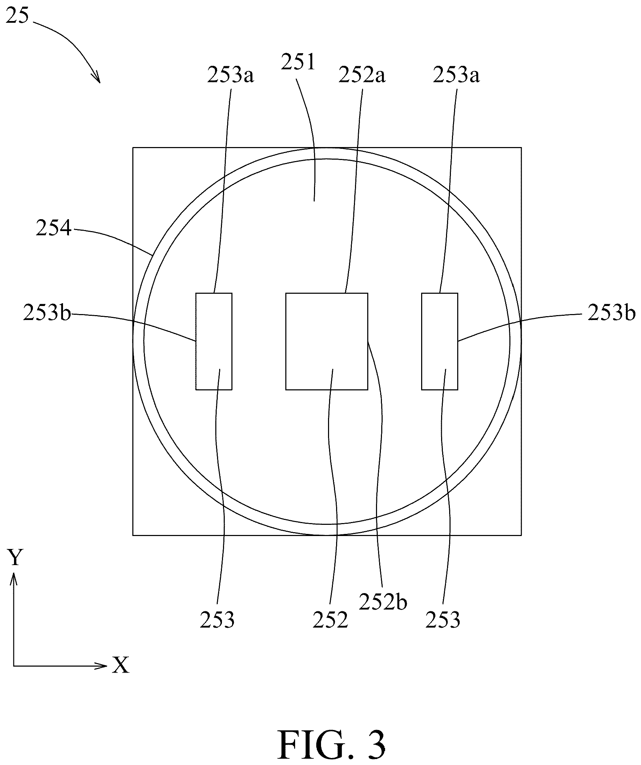

Referring to FIGS. 1 to 4, a first embodiment of a light-emitting module 2 according to the disclosure includes a bottom board 21, a surrounding wall 22 which extends upwardly from an outer periphery of the bottom board 21, a protecting cover 23 which is connected to the surrounding wall 22 and which is opposite to the bottom board 21, and a plurality of light-emitting units 25. The bottom board 21, the surrounding wall 22 and the protecting cover 23 cooperatively define a chamber 24 which has an opening covered by the protecting cover 23. The protecting cover 23 is light-transmissible. The bottom board 21, the surrounding wall 22 and the protecting cover 23 cooperatively form a housing. The light-emitting units 25 are separately disposed on (e.g., connected to) the bottom board 21 and are received in the chamber 24. The light-emitting units 25 are arranged along a first direction (X) and a second direction (Y) which intersects with the first direction (X) to form an array, and are electrically connected in series, in parallel or through other methods.

In certain embodiments, a vertical distance (D) between a surface of the protecting cover 23 which faces the light-emitting units 25 and a surface of the bottom board 21 is not less than 20 mm so as to provide enough light-mixing space, thereby reducing a color breakup phenomenon.

Specifically, each of the light-emitting units 25 includes a substrate 251, two electrodes 251a which are formed on the substrate 251, a first light-emitting element 252, two second light-emitting elements 253, a reflection element 254, an encapsulating layer 256, a phosphor material 257 which is distributed in the encapsulating layer 256, and conductive wires 258. In each of the light-emitting units 25, the first light-emitting element 252 and the second light-emitting elements 253 are disposed on the substrate 251. Arrangements of the first light-emitting element 252 and the second light-emitting elements 253 in each of the light-emitting units 25 are the same.

In each of the light-emitting units 25, the reflection element 254 is adapted to reflect lights, is connected to the substrate 251, and surrounds the first light-emitting element 252 and the second light-emitting elements 253. The reflection element 254 and the substrate 251 cooperatively define a recess 255 which has an opening that is opposite to the substrate 251. In this embodiment, an inner surface of the reflection element 254 that faces the first light-emitting element 252 is a continuous arc surface so that lights which are emitted from the first light-emitting element 252 and the second light-emitting elements 253 to the reflection element 254 may reflect more symmetrically so as to provide a more uniform color mixing effect, thereby further reducing the color breakup phenomenon of the light-emitting units 25.

In each of the light-emitting units 25, the first light-emitting element 252 and the second light-emitting elements 253 respectively emit the lights having different colors, are located in the recess 255, and are electrically connected to the electrodes 251a through the conductive wires 258.

In some embodiments, the first light-emitting element 252 and the second light-emitting elements 253 may be electrically connected in series so as to simplify circuit design.

For each of the light-emitting units 25, the first light-emitting element 252 and the second light-emitting elements 253 are respectively quadrilateral prisms and respectively have upper surfaces which are away from the bottom board 21. In each of the light-emitting units 25, the second light-emitting elements 253 are disposed at two opposite sides of the first light-emitting element 252. In each of the light-emitting units 25, a ratio of a length 253a of any one of the second light-emitting elements 253 parallel to the first direction (X) to a length 252a of the first light-emitting element 252 parallel to the first direction (X) ranges from 0.35 to 0.55. In each of the light-emitting units 25, a sum of areas of the upper surfaces of the second light-emitting elements 253 is not greater than an area of the upper surface of the first light-emitting element 252. In this embodiment, in each of the light-emitting units 25, the first light-emitting element 252 is a green **LED** (light-emitting diode) and the second light-emitting elements 253 are blue LEDs. In each of the light-emitting units 25, the second light-emitting elements 253 and the first light-emitting element 252 are arranged in the first direction (X) to form a structure as shown in FIG. 1.

In certain embodiments, in each of the light-emitting units 25, a ratio of a length 253b of any one of the second light-emitting elements 253 parallel to the second direction (Y) to a length 252b of the first light-emitting element 252 parallel to the second direction (Y) ranges from 0.9 to 1.2.

In some embodiments, in each of the light-emitting units 25, a ratio of the sum of the areas of the upper surfaces of the second light-emitting elements 253 to the area of the upper surface of the first light-emitting element 252 ranges from 0.7 to 1.0. Within this range, reduced color breakup phenomenon and superior color mixing may be obtained.

In each of the light-emitting units 25, the encapsulating layer 256 is made of a translucent material (e.g., epoxy resin or silicone resin), is filled in the recess 255, and covers the first light-emitting element 252, the second light-emitting elements 253 and the conductive wires 258.

In each of the light-emitting units 25, the phosphor material 257 is distributed in the encapsulating layer 256. A color of a light emitted by the phosphor material 257 is different from the color of the light emitted by the first light-emitting element 252 and the colors of the lights emitted by the second light-emitting elements 253. In this embodiment, the phosphor material 257 is phosphor powder which is able to absorb the lights emitted from the first light-emitting element 252 and the second light-emitting elements 253 (i.e., blue light and green light) and to emit red light. Materials for the phosphor material 257 may be KSF phosphor powder (potassium fluorosilicate, K₂SiF₆:Mn⁴⁺), quantum dots or a nitride phosphor material.

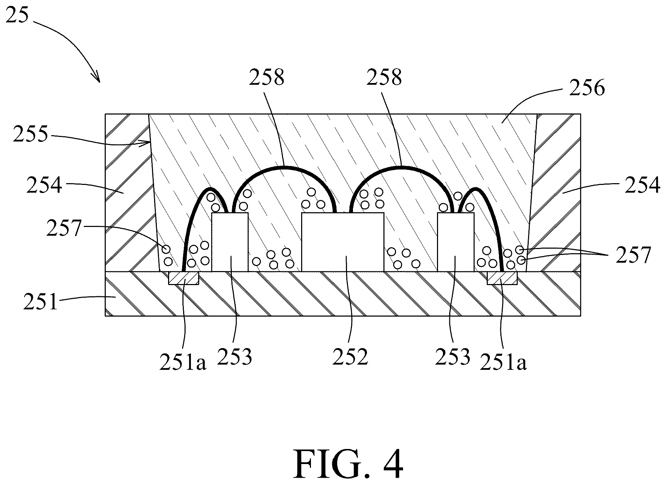

Referring to FIGS. 4 to 6, the phosphor material 257 may have different distribution configurations through process controlling.

For instance, in each of the light-emitting units 25, during formation of the encapsulating layer 256, the curing time of a liquid encapsulating material distributed with the phosphor material 257 may be delayed, allowing the phosphor material 257 to settle within the liquid encapsulating material, and concentrate on a surface of the substrate 251 and the upper surfaces of the first light-emitting element 252 and the second light-emitting elements 253 so as to obtain a distribution configuration shown in FIG. 4.

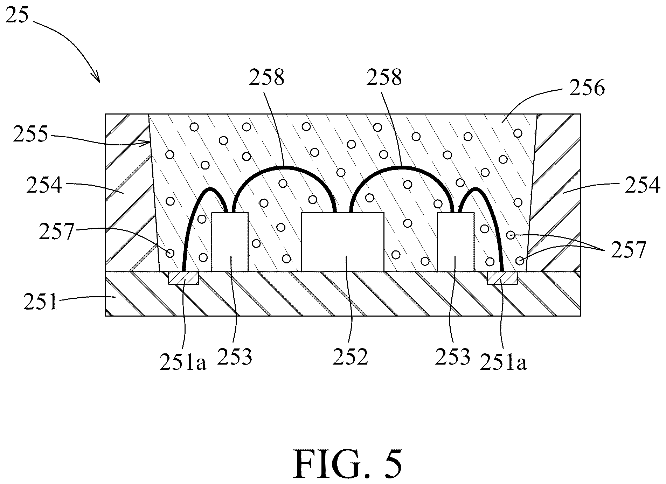

In certain embodiments, in each of the light-emitting units 25, the phosphor material 257 is evenly dispersed in the liquid encapsulating material in advance and the liquid encapsulating material is then immediately cured so that the phosphor material 257 may be uniformly distributed in the encapsulating layer 256 to obtain a distribution configuration shown in FIG. 5.

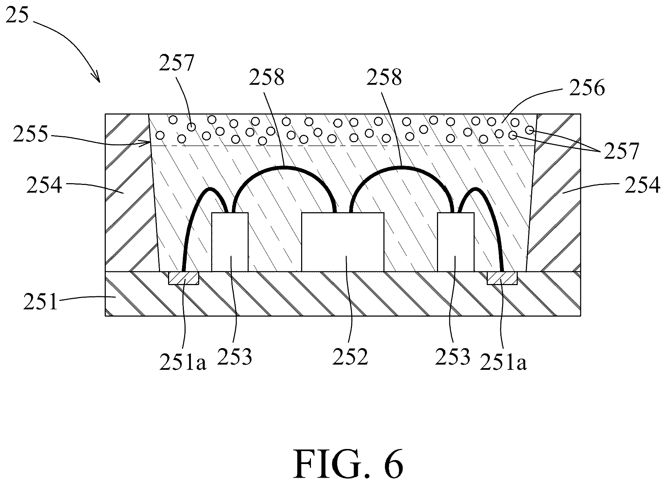

In some embodiments, in each of the light-emitting units 25, a portion of the liquid encapsulating material without the phosphor material 257 may first be filled in a lower portion of the recess 255 and cured to form a first portion of the encapsulating layer 256 which is free of the phosphor material 257. Thereafter, a portion of the liquid encapsulating material distributed with the phosphor material 257 is then added into the recess 255 on the first portion of the encapsulating layer 256, and then cured to form a second portion of the encapsulating layer 256 which is disposed on the first portion and contains the phosphor material 257, thereby obtaining a distribution configuration shown in FIG. 6. In these embodiments, the phosphor material 257 is concentrated at an end of the encapsulating layer 256 near the opening of the recess 255.

In the present disclosure, in each of the light-emitting units 25, through controlling the ratio of the length parallel to the first direction (X) and/or the ratio of the length parallel to the second direction (Y), i.e., from 0.35 to 0.55 (e.g., 0.44) and from 0.9 to 1.2 (e.g., 1.08), the arrangements of the first light-emitting element 252 and the second light-emitting elements 253, and the height of the chamber 24 (i.e., the vertical distance), an illuminating range of the light emitted from the first light-emitting element 252 to the opening of the chamber 24 may cover an illuminating range of the lights emitted from the second light-emitting elements 253 to the opening of the chamber 24, thereby alleviating the color breakup phenomenon. If the ratio(s) do not fall in the corresponding ranges (e.g., the ratio with regard to the first direction (X) is 0.79 or 1.00), the color breakup phenomenon would be occurred.

Specially, the first light-emitting element 252 and the second light-emitting elements 253 of each of the light-emitting units 25 have narrow emission bands. Moreover, when the phosphor material 257 is KSF phosphor powder, the color mixing of the lights in the light-emitting module 2 according to the disclosure may be accurately controlled.

In some embodiments, a color gamut of the light-emitting module 2 according to the disclosure satisfies some standards of color rendering index. For instance, a color coverage is not less than 75% of Rec.2020, 90% of DCI-P3 and 97% of standard Red Green Blue (sRGB) color space, and the color gamut may attain approximately 100% of the area of the NTSC standard.

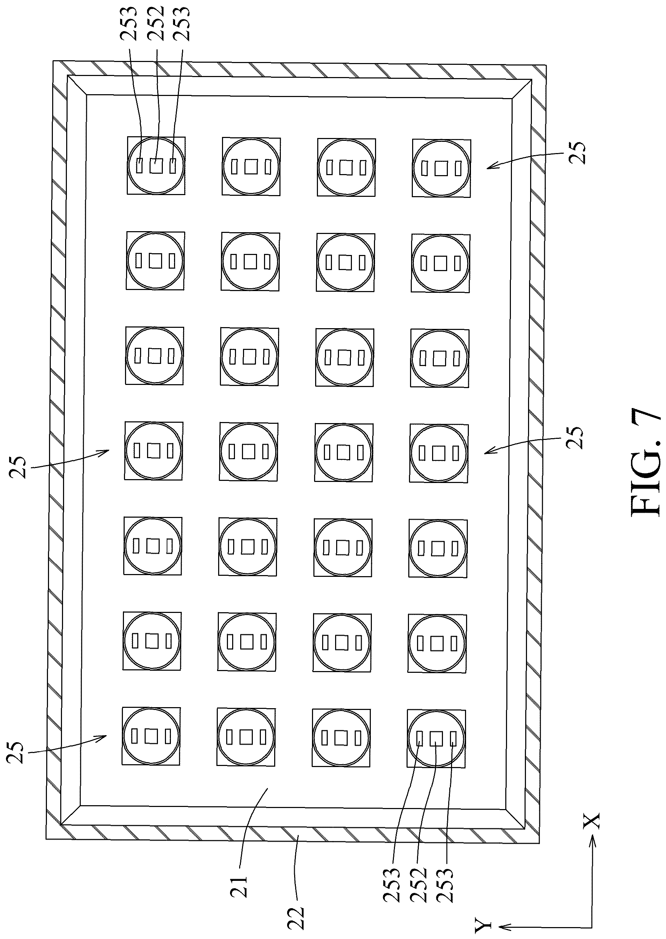

FIG. 7 illustrates a second embodiment of the light-emitting module 2 according to the disclosure. The second embodiment of the light-emitting module 2 is similar to the first embodiment, except that, in the second embodiment, in each of the light-emitting units 25, the second light-emitting elements 253 and the first light-emitting element 252 are arranged in the second direction (Y). With such arrangement, the color breakup phenomenon may also be reduced.

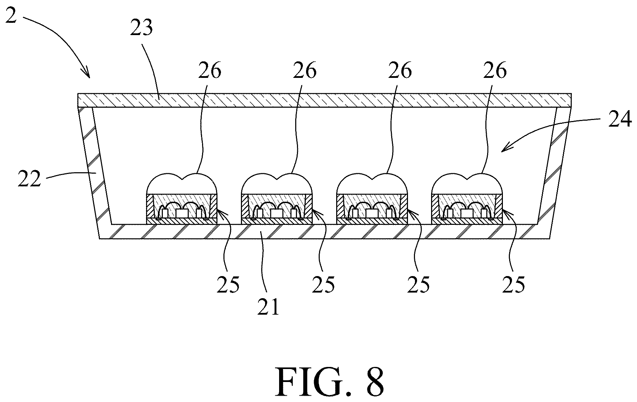

Referring to FIG. 8, in some embodiments, the light-emitting module 2 may further includes lenses 26 which are respectively located on surfaces of the light-emitting units 25 that face the protecting cover 23. Each of the lenses 26 may be a refractive lens or a reflective lens. The illuminating ranges of the lights emitted from the light-emitting units 25 may be enlarged through the lenses 26. Moreover, by virtue of the design of the first light-emitting element 252 and the second light-emitting elements 253 in each of the light-emitting units 25, uniform light emission may be still accomplished and a drawback of the color breakup which may become more serious due to the existence of the lenses 26 might be prevented. The aforementioned refractive lens and reflective lens are known to those skilled in the art, so detailed descriptions thereof are omitted herein.

In summary, through the design of the ratios of the lengths and the arrangements of the first light-emitting element 252 and the second light-emitting elements 253 in each of the light-emitting units 25 of the light-emitting module 2 according to the disclosure, the illuminating ranges of the emitted lights are overlapped so as to reduce the color breakup phenomenon. Furthermore, when the first light-emitting element 252, the second light-emitting elements 253 and the phosphor material 257 are respectively the green LED, the blue LED and the red phosphor powder (KSF), which all have narrow emission bands, the light-emitting module 2 according to the disclosure may have superior coloring rendering, thereby indeed achieving purposes of the disclosure.

In the description above, for the purposes of explanation, numerous specific details have been set forth in order to provide a thorough understanding of the embodiment(s). It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects; such does not mean that every one of these features needs to be practiced with the presence of all the other features. In other words, in any described embodiment, when implementation of one or more features or specific details does not affect implementation of another one or more features or specific details, said one or more features may be singled out and practiced alone without said another one or more features or specific details. It should be further noted that one or more features or specific details from one embodiment may be practiced together with one or more features or specific details from another embodiment, where appropriate, in the practice of the disclosure.

## Claims

1. A light-emitting module (2), comprising:
a housing which includes a bottom board (21); and
light-emitting units (25) which are separately disposed on said bottom board (21) and which are arranged along a first direction (X) and a second direction (Y) intersecting with the first direction (X) to form an array, each of said light-emitting units (25) including a first light-emitting element (252) and two second light-emitting elements (253) which emit lights having colors different from a color of a light emitted by said first light-emitting element (252),
**characterized in that**, for each of said light-emitting units (25), said first light-emitting element (252) and said second light-emitting elements (253) are respectively quadrilateral prisms and respectively have upper surfaces away from said bottom board (21), said second light-emitting elements (253) being disposed at two opposite sides of said first light-emitting element (252), a ratio of a length (253a) of any one of said second light-emitting elements (253) parallel to the first direction (X) to a length (252a) of said first light-emitting element (252) parallel to the first direction (X) ranging from 0.35 to 0.55, a sum of areas of said upper surfaces of said second light-emitting elements (253) being not greater than an area of said upper surface of said first light-emitting element (252).

2. The light-emitting module (2) as claimed in claim 1, wherein arrangements of said first light-emitting element (252) and said second light-emitting elements (253) in each of said light-emitting units (25) are the same.

3. The light-emitting module (2) as claimed in any one of claims 1 and 2, wherein, in each of said light-emitting units (25), a ratio of a length (253b) of any one of said second light-emitting elements (253) parallel to the second direction (Y) to a length (252b) of said first light-emitting element (252) parallel to the second direction (Y) ranges from 0.9 to 1.2.

4. The light-emitting module (2) as claimed in any one of claims 1 to 3, wherein, in each of said light-emitting units (25), a ratio of the sum of the areas of said upper surfaces of said second light-emitting elements (253) to the area of said upper surface of said first light-emitting element (252) ranges from 0.7 to 1.0.

5. The light-emitting module (2) as claimed in any one of claims 1 to 4, wherein each of said light-emitting units (25) further includes:
a substrate (251) on which said first light-emitting element (252) and said second light-emitting elements (253) are disposed;
a reflection element (254) which is connected to said substrate (251) and which surrounds said first light-emitting element (252) and said second light-emitting elements (253), said reflection element (254) defining an opening that is opposite to said substrate (251);
an encapsulating layer (256) which covers said first light-emitting element (252) and said second light-emitting elements (253); and
a phosphor material (257) which is distributed in said encapsulating layer (256), a color of a light emitted by said phosphor material (257) being different from the color of the light emitted by said first light-emitting element (252) and the colors of the lights emitted by said second light-emitting elements (253).

6. The light-emitting module (2) as claimed in claim 5, wherein an inner surface of said reflection element (254) facing said first light-emitting element (252) is a continuous arc surface.

7. The light-emitting module (2) as claimed in any one of claims 5 and 6, wherein said phosphor material (257) is red phosphor powder.

8. The light-emitting module (2) as claimed in claim 7, wherein said red phosphor powder is potassium fluorosilicate phosphor.

9. The light-emitting module (2) as claimed in any one of claims 5 to 8, wherein said phosphor material (257) is concentrated on a surface of said substrate (251) and said upper surface of said first light-emitting element (252) and said upper surfaces of said second light-emitting elements (253) in each of said light-emitting units (25).

10. The light-emitting module (2) as claimed in any one of claims 5 to 8, wherein said phosphor material (257) is uniformly distributed in said encapsulating layer (256).

11. The light-emitting module (2) as claimed in any one of claims 5 to 8, wherein said encapsulating layer (256) has a first portion which is adjacent to said substrate (251) and free of said phosphor material (257), and a second portion which is disposed on said first portion away from said substrate (251) and contains said phosphor material (257) therein.

12. The light-emitting module (2) as claimed in any one of claims 1 to 11, wherein said housing further includes:
a surrounding wall (22) which extends upwardly from an outer periphery of said bottom board (21); and
a protecting cover (23) which is light-transmissible, which is connected to said surrounding wall (22) and which is opposite to said bottom board (21),
wherein said bottom board (21), said surrounding wall (22) and said protecting cover (23) define a chamber (24), said light-emitting units (25) being disposed in said chamber (24).

13. The light-emitting module (2) as claimed in claim 12, wherein a distance between a surface of said protecting cover (23) facing said light-emitting units (25) and said bottom board (21) is not less than 20 mm.

14. The light-emitting module (2) as claimed in any one of claims 1 to 13, wherein, in each of said light-emitting units (25), said second light-emitting elements (253) and said first light-emitting element (252) are arranged in the first direction (X).

15. The light-emitting module (2) as claimed in any one of claims 1 to 13, wherein, in each of said light-emitting units (25), said second light-emitting elements (253) and said first light-emitting element (252) are arranged in the second direction (Y).
